# EUROPEAN PATENT APPLICATION

(11) **EP 4 235 752 A1**
(43) Date of publication of application: **30.08.2023**
(21) Application number: 21882661.8
(22) Date of filing: 12.10.2021
(51) Int. Cl.: H01L 21/3065

(54) **ETCHING METHOD AND METHOD FOR PRODUCING SEMICONDUCTOR ELEMENT**

(30) Priority: 22.10.2020 JP 2020177618
(71) Applicant: Resonac Corporation, Tokyo 105-8518 (JP)
(72) Inventor: IWASAKI, Jumpei, Tokyo 105-8518 (JP); TANIMOTO, Yosuke, Tokyo 105-8518 (JP); MATSUI, Kazuma, Tokyo 105-8518 (JP)
(74) Representative: Strehl Schübel-Hopf & Partner
(86) International application number: PCT/JP2021/037774
(87) International publication number: WO 2022/085520

(57) **Abstract**

To selectively etch an etching object as compared with a non-etching object while damage to an etching system is suppressed. An etching method includes: an etching step of bringing an etching gas which contains nitrosyl fluoride and has been converted into plasma into contact with a member to be etched (9) having an etching object and a non-etching object and selectively etching the etching object as compared with the non-etching object. The etching step is performed in a chamber (7) containing the member to be etched (9) using a remote plasma generation device (16) provided outside the chamber (7) as a plasma generation source. The concentration of nitrosyl fluoride in the etching gas is 0.3% by volume or more, the temperature condition of the etching step is 0°C or more and 250°C or less, and the pressure condition of the etching step is 100 Pa or more and 3 kPa or less. The etching object includes silicon nitride.

## Description

### Technical Field

The present invention relates to an etching method and a method for producing a semiconductor device.

### Background Art

Silicon nitride is a material used in semiconductor devices, such as flash memories, and has problems of a low etching selectivity (capability of selectively etching silicon nitride as compared with the other silicon materials) and a low etching rate when etched from the other silicon materials, such as silicon oxides.

As an etching method for solving these problems, dry etching is mentioned. In particular, dry etching using nitrosyl fluoride (NOF) as an etching gas has high etching selectivity when silicon nitride is etched from silicon oxide.

PTL 1, for example, discloses a method for producing a semiconductor device for use as a 3D-NAND device by dry etching using nitrosyl fluoride as an etching gas. In this production method, by the dry etching using nitrosyl fluoride as an etching gas, horizontal isotropic etching is applied to silicon nitride layers of a laminate obtained by alternately laminating silicon nitride films and silicon oxide films.

### Citation List

### Patent Literature

PTL 1: US 10529581 B

### Summary of Invention

### Technical Problem

However, in the dry etching disclosed in PTL 1, it is necessary to perform the etching under a higher temperature and higher pressure environment where the temperature is 250 to 400°C and the pressure is 100 to 400 Torr (13330 to 53330 Pa) as compared with common etching conditions, and therefore the dry etching has posed a risk of damaging an etching system.

It is an object of the present invention to provide an etching method capable of selectively etching an etching object having silicon nitride as compared with a non-etching object while suppressing damage to an etching system and a method for producing a semiconductor device.

### Solution to Problem

To achieve the above-described object, one aspect of the present invention is as described in [1] to [8] below.
[1] An etching method includes: an etching step of bringing an etching gas which contains nitrosyl fluoride and has been converted into plasma into contact with a member to be etched having an etching object which is an object to be etched by the etching gas and a non-etching object which is not an object to be etched by the etching gas and selectively etching the etching object as compared with the non-etching object, in which
   the etching step is performed in a chamber containing the member to be etched using a remote plasma generation device provided outside the chamber as a plasma generation source,
   the concentration of the nitrosyl fluoride in the etching gas is 0.3% by volume or more, the temperature condition of the etching step is 0°C or more and 250°C or less, and the pressure condition of the etching step is 100 Pa or more and 3 kPa or less, and
   the etching object includes silicon nitride.
[2] The etching method according to [1], in which the source power of the remote plasma generation device of the etching step is 100 W or more and 1 kW or less.
[3] The etching method according to [1] or [2], in which the non-etching object includes silicon oxide.
[4] The etching method according to any one of [1] to [3], in which the etching gas is a mixed gas containing the nitrosyl fluoride and a dilution gas, the dilution gas is at least one selected from a nitrogen gas, helium, argon, neon, krypton, and xenon, and the concentration of the dilution gas in the etching gas is 99.7% by volume or less.
[5] The etching method according to any one of [1] to [4], in which the temperature condition of the etching step is 5°C or more and 200°C or less.
[6] The etching method according to any one of [1] to [5], in which the pressure condition of the etching step is 200 Pa or more and 2 kPa or less.
[7] The etching method according to any one of [1] to [6], in which the source power of the remote plasma generation device of the etching step is 200 W or more and 900 W or less.
[8] A method for producing a semiconductor device for producing a semiconductor device using the etching method according to any one of [1] to [7],
   the member to be etched being a semiconductor substrate having the etching object and the non-etching object; and the method includes:
   a treatment step of removing at least a part of the etching object from the semiconductor substrate by the etching.

### Advantageous Effects of Invention

According to the present invention, the etching object having silicon nitride can be selectively etched as compared with the non-etching object while damage to the etching system is suppressed.

### Brief Description of Drawings

FIG. 1 is a schematic view of one example of an etching system for explaining one embodiment of an etching method according to the present invention;
FIG. 2 illustrates views for explaining a member to be etched used in Examples 1 to 21 and Comparative Examples 1 to 7; and
FIG. 3 is a view for explaining a member to be etched used in Examples 22 to 24 and Comparative Example 8.

### Description of Embodiments

Hereinafter, one embodiment of the present invention will be described. This embodiment describes one example of the present invention, and the present invention is not limited to this embodiment. Further, this embodiment can be variously altered or modified and embodiments obtained by such alternations or modifications may also be included in the present invention.

An etching method according to this embodiment includes an etching step of bringing an etching gas which contains nitrosyl fluoride and has been converted into plasma into contact with a member to be etched having an etching object which is an object to be etched by the etching gas and a non-etching object which is not an object to be etched by the etching gas and selectively etching the etching object as compared with the non-etching object.

This etching step is performed in a chamber containing the member to be etched. As a plasma generation source converting the etching gas into plasma, a remote plasma generation device provided outside the chamber is used.

The concentration of nitrosyl fluoride in the etching gas is 0.3% by volume or more. The temperature condition of the etching step is 0°C or more and 250°C or less. The pressure condition of the etching step is 100 Pa or more and 3 kPa or less. The etching object includes silicon nitride. The source power of the remote plasma generation device of the etching step is preferably 100 W or more and 1 kW or less.

When the etching gas which has been converted into plasma is brought into contact with the member to be etched, nitrosyl fluoride in the etching gas reacts with silicon nitride in the etching object, and therefore the etching of the etching object proceeds. On the other hand, the non-etching object hardly reacts with nitrosyl fluoride, and therefore the etching of the non-etching object hardly proceeds. Therefore, according to the etching method of this embodiment, the etching object can be selectively etched as compared with the non-etching object. Further, according to the etching method of this embodiment, silicon nitride can be etched at a high etching rate.

By converting the etching gas into plasma using the remote plasma generation device and performing the etching under the above-described low temperature and low pressure environment, the etching object having silicon nitride can be selectively etched as compared with the non-etching object while damage applied to an etching system (e.g., chamber) is suppressed.

The etching in the present invention means processing the member to be etched into a predetermined shape (e.g., three-dimensional shape) by partially or entirely removing the etching object possessed by the member to be etched (e.g., processing the etching object in a film shape containing silicon nitride possessed by the member to be etched to have a predetermined film thickness) and means cleaning the member to be etched by removing residues and deposits containing the etching object from the member to be etched, for example.

The etching method according to this embodiment can be utilized for producing semiconductor devices. More specifically, the method for producing a semiconductor device according to this embodiment is a method for producing a semiconductor device using the etching method according to this embodiment. The member to be etched is a semiconductor substrate having the etching object and the non-etching object. The method includes a treatment step of removing at least a part of the etching object from the semiconductor substrate by etching.

For example, in the etching method according to this embodiment, the etching of silicon nitride (e.g., Si₃N₄) more rapidly proceeds than the etching of silicon oxide (e.g., SiO₂). By utilizing this property, the etching method according to this embodiment is usable for producing semiconductor devices, such as 3D-NAND flash memories and logic devices.

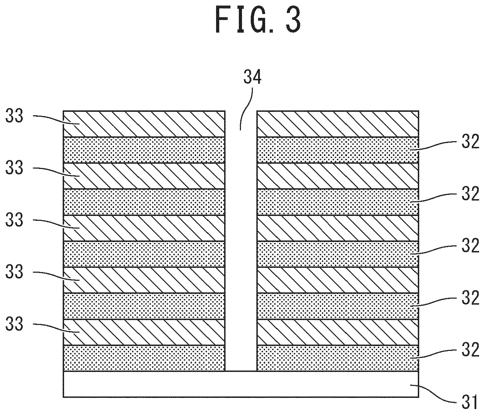

For example, by applying the etching method according to this embodiment to a laminate obtained by alternately laminating silicon oxide films and silicon nitride films formed with a through hole extending along the lamination direction and passing through the laminate (see FIG. 3), the silicon nitride films exposed to the inner surface of the through hole are selectively and isotropically etched, and therefore a structure can be formed in which end parts of the silicon oxide films project into the through hole. A process of forming a structure body having such a structure can utilize the structure body as a structure body of semiconductor devices, and therefore the process is utilized for producing semiconductor devices, such as 3D-NAND flash memories and logic devices.

The process of forming the structure by etching has been conventionally performed using chemical solutions containing phosphoric acid or the like, but the etching using an etching gas is superior to the etching using the chemical solutions in terms of microfabrication. Therefore, the etching method according to this embodiment can be expected to contribute to further miniaturization and higher integration of semiconductor devices.

Similarly, when the non-etching object itself is used as the structure body of semiconductor devices, materials that do not substantially react with nitrosyl fluoride or materials that react extremely slowly with nitrosyl fluoride are used as the non-etching object. Specifically, silicon oxide (e.g., SiO₂) is usable, for example.

Further, the etching method according to this embodiment can be utilized for cleaning as described above. For example, after a step of forming a film containing materials containing silicon nitrides on a substrate or a step of etching a film of materials containing silicon nitrides formed on a substrate is performed in a chamber, attached matter containing silicon nitrides attached to the inner surface of the chamber can be removed by the etching method according to this embodiment for cleaning. In such cleaning, the chamber is equivalent to the member to be etched, which is a constituent requirement of the present invention, and the attached matter is equivalent to the etching object, which is a constituent requirement of the present invention.

Hereinafter, the etching method and the method for producing a semiconductor device according to this embodiment are described in more detail.

### [Plasma generation source]

The etching in this embodiment can be achieved by plasma etching. The type of the plasma generation source in the plasma etching is not particularly limited, and commercially available devices may be used. For example, high-frequency discharge plasma, such as Inductively Coupled Plasma (ICP) and Capacitively Coupled Plasma (CCP), and microwave discharge plasma, such as Electron Cyclotron Resonance Plasma (ECRP), are mentioned.

The plasma is generated in a plasma generation chamber while the plasma generation chamber and a chamber where the member to be etched is installed are separated (i.e., remote plasma is used). By the etching using the remote plasma, the etching object having silicon nitride can be etched with high selectivity. An etching method for performing etching in a chamber by plasma of an etching gas generated outside the chamber by the plasma generation source is sometimes referred to as "remote plasma etching".

The source power of the remote plasma generation device in the etching step is preferably 100 W or more and 1 kW or less, more preferably 200 W or more and 900 W or less, and still more preferably 300 W or more and 800 W or less.

### [Etching gas]

The etching gas is a gas containing nitrosyl fluoride, and may be a gas containing only nitrosyl fluoride or a mixed gas containing nitrosyl fluoride and the other types of gases. The concentration of nitrosyl fluoride in the etching gas needs to be 0.3% by volume or more and is preferably 0.5% by volume or more and 50% by volume or less and more preferably 2% by volume or more and 30% by volume or less.

When the plasma etching is performed with the concentration of nitrosyl fluoride in the etching gas set within the ranges above, the etching object having silicon nitride can be selectively etched as compared with the non-etching object. For example, an etching selectivity ratio, which is a ratio of the etching rate of the etching object to the etching rate of the non-etching object, tends to be 15 or more. The etching selectivity ratio is preferably 15 or more, more preferably 17 or more, and still more preferably 20 or more.

As the other types of gases constituting the etching gas together with a gas of nitrosyl fluoride, an inert dilution gas is usable. More specifically, the etching gas can be a mixed gas containing nitrosyl fluoride and a dilution gas.

As the dilution gas, at least one selected from a nitrogen gas (N₂), helium (He), neon (Ne), argon (Ar), krypton (Kr), and xenon (Xe) is usable.

The concentration of the dilution gas in the etching gas needs to be 99.7% by volume or less and is preferably 50% by volume or more and 99.5% by volume or less and more preferably 70% by volume or more and 98% by volume or less.

### [Pressure condition of etching step]

The pressure condition of the etching step in the etching method according to this embodiment needs to be set to 100 Pa or more and 3 kPa or less and is set to preferably 200 Pa or more and 2 kPa or less and more preferably 300 Pa or more and 1 kPa or less. When the pressure condition is within the ranges above, plasma is easily stably generated.

For example, the etching can be performed while the member to be etched is arranged in the chamber and the etching gas is circulated in the chamber. The pressure inside the chamber in the circulation of the etching gas is set to 100 Pa or more and 3 kPa or less. The flow rate of the etching gas may be set as appropriate such that the pressure inside the chamber is kept constant according to the size of the chamber and the capacity of exhaust equipment reducing the pressure inside the chamber.

### [Temperature condition of etching step]

The temperature condition of the etching step in the etching method according to this embodiment needs to be set to 0°C or more and 250°C or less and is set to preferably 5°C or more and 200°C or less and more preferably 10°C or more and 150°C or less.

When the temperature condition is within the ranges above, nitrosyl fluoride can be present in a gaseous state and the etching rate of silicon nitride tends to be higher. Herein, the temperature of the temperature condition is the temperature of the member to be etched, but it is also possible to use the temperature of a stage installed in a chamber of an etching system and supporting the member to be etched.

Nitrosyl fluoride hardly reacts with the non-etching object, such as silicon oxide, at temperatures equal to or less than 250°C. Therefore, when the member to be etched is etched by the etching method according to this embodiment, the etching object having silicon nitride can be selectively etched while the non-etching object is hardly etched. Therefore, the etching method according to this embodiment can be utilized for a method for processing the etching object having silicon nitride into a predetermined shape using the non-etching object subjected to patterning as a resist or a mask.

When the temperatures of the etching object and the non-etching object are 150°C or less, the etching selectivity tends to increase. For example, the etching selectivity ratio which is the ratio of the etching rate of the etching object having silicon nitride to the etching rate of the non-etching object tends to be 15 or more.

### [Member to be etched]

The member to be etched which is etched by the etching method according to this embodiment has the etching object and the non-etching object, but a member having a part formed of the etching object and a part formed of the non-etching object may be acceptable or a member formed of a mixture of the etching object and the non-etching object may be acceptable. The member to be etched may have something other than the etching object and the non-etching object.

The shape of the member to be etched is not particularly limited, and may be a plate shape, a foil shape, a film shape, a powder shape, or a block shape, for example. Examples of the member to be etched include the aforementioned semiconductor substrate.

### [Etching object]

The etching object includes silicon nitride and may be one formed of only silicon nitride, may be one having a part formed of only silicon nitride and a part formed of the other materials, or may be one formed of a mixture of silicon nitride and the other materials.

Silicon nitride refers to compounds having silicon and nitrogen in any proportion, and Si₃N₄ can be mentioned as an example. The purity of silicon nitride is not particularly limited, and is preferably 30% by mass or more, more preferably 60% by mass or more, and still more preferably 90% by mass or more.

The shape of the etching object is not particularly limited, and may be a plate shape, a foil shape, a film shape, a powder shape, or a block shape, for example.

### [Non-etching object]

The non-etching object does not substantially react with nitrosyl fluoride or extremely slowly reacts with nitrosyl fluoride, and therefore, even when the etching is performed by the etching method according to this embodiment, the etching hardly proceeds. The non-etching object is not particularly limited insofar as it has the above-described properties, and silicon oxide is mentioned, for example.

Further, the non-etching object is usable as a resist or a mask for suppressing the etching of the etching object by the etching gas. Therefore, the etching method according to this embodiment is usable for a method for processing the etching object into a predetermined shape (for example, processing the etching object in a film shape possessed by the member to be etched to have a predetermined film thickness) utilizing the non-etching object subjected to patterning as a resist or a mask, for example, and therefore can be suitably used for producing a semiconductor device. Further, the non-etching object is hardly etched, and therefore it is possible to suppress the etching of parts not to be etched of the semiconductor device and to prevent the loss of the properties of the semiconductor device by the etching.

The non-etching object left after the patterning can be removed by a removal method commonly used in a semiconductor device production step. For example, ashing using an oxidizing gas, such as oxygen plasma or ozone, or dissolving and removing using a chemical solution, such as APM (mixed liquid of ammonia water and hydrogen peroxide water), SPM (mixed liquid of sulfuric acid and hydrogen peroxide), or an organic solvent, is mentioned.

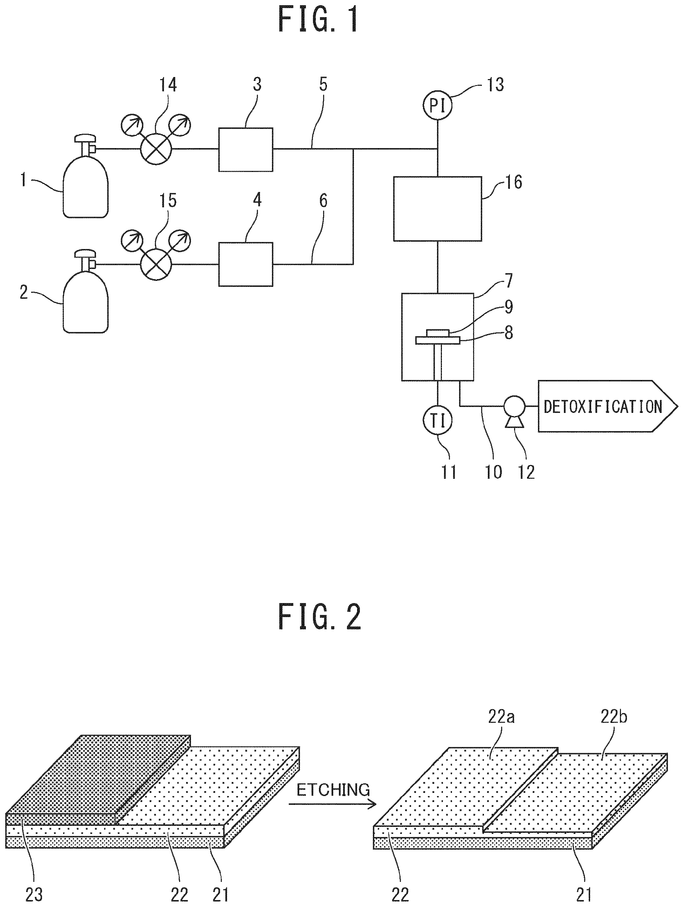

Next, one example of the configuration of an etching system capable of implementing the etching method according to this embodiment and one example of an etching method using the etching system are described with reference to FIG. 1. The etching system in FIG. 1 is a remote plasma etching system performing remote plasma etching. First, the etching system in FIG. 1 is described. The etching system in FIG. 1 includes a chamber 7 inside which etching is performed, a remote plasma generation device 16 which is a plasma generation source, a stage 8 supporting a member to be etched 9 to be etched inside the chamber 7, a thermometer 11 measuring the temperature of the member to be etched 9, an exhaust pipe 10 for exhausting gas inside the chamber 7, a vacuum pump 12 provided in the exhaust pipe 10 and reducing the pressure inside the chamber 7, and a pressure gauge 13 measuring the pressure inside the chamber 7.

The etching system in FIG. 1 further includes an etching gas supply unit supplying an etching gas into the chamber 7. The etching gas supply unit includes a nitrosyl fluoride gas supply unit 1 supplying a gas of nitrosyl fluoride, a noble gas supply unit 2 supplying a noble gas, a nitrosyl fluoride gas supply pipe 5 connecting the nitrosyl fluoride gas supply unit 1 and the chamber 7, and a noble gas supply pipe 6 connecting the noble gas supply unit 2 to an intermediate part of the nitrosyl fluoride gas supply pipe 5.

The etching system in FIG. 1 has a remote plasma generation device 16 outside the chamber 7. In detail, the etching system in FIG. 1 has a remote plasma generation device 16 at a position between a connection part with the noble gas supply pipe 6 in the nitrosyl fluoride gas supply pipe 5 and the chamber 7.

The nitrosyl fluoride gas supply pipe 5 is further provided with a nitrosyl fluoride gas pressure control device 14 controlling the pressure of the gas of nitrosyl fluoride and a nitrosyl fluoride gas flow rate control device 3 controlling the flow rate of the gas of nitrosyl fluoride. The noble gas supply pipe 6 is further provided with a noble gas pressure control device 15 controlling the pressure of the noble gas and a noble gas flow rate control device 4 controlling the flow rate of the noble gas.

When the gas of nitrosyl fluoride is supplied as the etching gas to the chamber 7, the gas of nitrosyl fluoride is sent from the nitrosyl fluoride gas supply unit 1 to the nitrosyl fluoride gas supply pipe 5, so that the gas of nitrosyl fluoride is supplied to the remote plasma generation device 16 through the nitrosyl fluoride gas supply pipe 5.

When a mixed gas of the gas of nitrosyl fluoride and the noble gas is supplied as the etching gas, the gas of nitrosyl fluoride is sent from the nitrosyl fluoride gas supply unit 1 to the nitrosyl fluoride gas supply pipe 5 and the noble gas is sent from the noble gas supply unit 2 to the nitrosyl fluoride gas supply pipe 5 through the noble gas supply pipe 6, so that the mixed gas is supplied to the remote plasma generation device 16 through the nitrosyl fluoride gas supply pipe 5.

Then, the gas of nitrosyl fluoride or the mixed gas is converted into plasma in the remote plasma generation device 16 and supplied into the chamber 7. The remote plasma generation device 16 and the chamber 7 may be directly connected or may be connected by a pipe.

The configurations of the nitrosyl fluoride gas supply unit 1 and the noble gas supply unit 2 are not particularly limited, and tanks, cylinders, or the like may be acceptable, for example. As the nitrosyl fluoride gas flow rate control device 3 and the noble gas flow rate control device 4, a mass flow controller, a flow meter, and the like can be utilized, for example.

When the etching gas is supplied to the chamber 7, the etching gas is preferably supplied while the pressure of the etching gas (i.e., the value of the nitrosyl fluoride gas pressure control device 14 in FIG. 1) is held at a predetermined value. More specifically, the supply pressure of the etching gas is preferably 1 Pa or more and 0.2 MPa or less, more preferably 10 Pa or more and 0.1 MPa or less, and still more preferably 50 Pa or more and 50 kPa or less. When the supply pressure of the etching gas is within the ranges above, the etching gas is smoothly supplied to the chamber 7 and a load to the parts (for example, the various devices and pipes) possessed by the etching system in FIG. 1 is small.

The pressure of the etching gas supplied into the chamber 7 is preferably 1 Pa or more and 80 kPa or less, more preferably 10 Pa or more and 50 kPa or less, and still more preferably 100 Pa or more and 20 kPa or less from the viewpoint of uniformly etching the surface of the member to be etched 9. When the pressure of the etching gas in the chamber 7 is within the ranges above, a sufficient etching rate can be obtained and the etching selectivity ratio tends to be high.

The pressure inside the chamber 7 before the etching gas is supplied is not particularly limited insofar as the pressure is equal to or less than the supply pressure of the etching gas or less than the supply pressure of the etching gas, and is preferably 10⁻⁵ Pa or more and less than 10 kPa and more preferably 1 Pa or more and 2 kPa or less, for example.

A differential pressure between the supply pressure of the etching gas and the pressure inside the chamber 7 before the etching gas is supplied is preferably 0.5 MPa or less, more preferably 0.3 MPa or less, and still more preferably 0.1 MPa or less. When the differential pressure is within the ranges above, the etching gas is easily smoothly supplied to the chamber 7.

When the etching gas is supplied to the chamber 7, it is preferable to supply the etching gas while the temperature of the etching gas is held at a predetermined value. More specifically, the supply temperature of the etching gas is preferably 0°C or more and 150°C or less.

The temperature of the member to be etched 9 when performing the etching needs to be set to 0°C or more and 250°C or less and is set to preferably 5°C or more and 200°C or less and more preferably 10°C or more and 150°C or less. Within the temperature ranges above, the etching of the etching object (particularly silicon nitride) possessed by the member to be etched 9 smoothly proceeds, a load to the etching system is small, and the life of the etching system tends to be long.

An etching treatment time (hereinafter also referred to as "etching time") can be arbitrarily set depending on how much the etching object possessed by the member to be etched 9 is desired to be etched and is preferably within 60 minutes, more preferably within 40 minutes, and still more preferably within 20 minutes considering the production efficiency of a semiconductor device producing process. The etching treatment time refers to a time during which the etching gas which has been converted into plasma is brought into contact with the member to be etched 9 inside the chamber 7.

The etching method according to this embodiment can be performed using a common plasma etching system used in the semiconductor device production step, such as the etching system in FIG. 1, and the configuration of the usable etching system is not particularly limited.

For example, the positional relationship between the nitrosyl fluoride gas supply pipe 5 and the member to be etched 9 is not particularly limited insofar as the etching gas can be brought into contact with the member to be etched 9. Also with respect to the configuration of a temperature control mechanism of the chamber 7, it is sufficient when the temperature of the member to be etched 9 can be adjusted to any temperature. Therefore, a configuration may be acceptable in which the temperature control mechanism is provided directly on the stage 8 or the chamber 7 may be warmed or cooled from the outside of the chamber 7 using the temperature control mechanism externally attached.

A material of the etching system in FIG. 1 is not particularly limited insofar as it has corrosion resistance to nitrosyl fluoride and can be subjected to a pressure reduction to a predetermined pressure. For example, metals, such as stainless steel, ceramics, such as alumina, fluororesins, and the like are usable for portions contacting the etching gas.

Examples of the fluororesins include polytetrafluoroethylene (PTFE), polychlorotrifluoroethylene (PCTFE), a tetrafluoroethylene-perfluoroalkoxyethylene copolymer (PFA), polyvinylidene fluoride (PVDF), Teflon (registered trademark), Viton (registered trademark), Kalrez (registered trademark), and the like, for example.

### EXAMPLES

Hereinafter, the present invention is more specifically described with reference to Examples and Comparative Examples.

### (Example 1)

A member to be etched was etched using an etching system having substantially the same configuration as that of the etching system in FIG. 1. The member to be etched used in Example 1 is described with reference to FIG. 2.

A silicon substrate 21 having a square shape of 2 inches on a side on which a silicon nitride film 22 having a film thickness of 1 um was formed (manufactured by SEIREN KST Corp.) was prepared. Onto the silicon nitride film 22, a rectangular silicon dioxide substrate 23 with a dimension of 1 inch × 2 inches was bonded using grease (Demnum Grease L-200 manufactured by Daikin Industries, Ltd.), and a laminate thus manufactured was used as the member to be etched. The silicon dioxide substrate 23 was bonded to cover approximately the half of the silicon nitride film 22 as illustrated in FIG. 2. The silicon nitride film 22 is the etching object, and the silicon dioxide substrate 23, which is the non-etching object, is used as a resist.

Further, a laminate for comparison was manufactured in which the silicon nitride film 22 which is the etching object was replaced with a film of silicon dioxide which is the non-etching object in the member to be etched.

The member to be etched and the laminate for comparison were placed side by side on a stage inside a chamber of the etching system, and the temperature of the stage was set to 20°C.

Next, a gas of nitrosyl fluoride at a flow rate of 30 mL/min and argon at a flow rate of 970 mL/min were mixed to form a mixed gas, and the mixed gas was used as an etching gas. Then, the etching gas was supplied into the chamber at a flow rate of 1000 mL/min and circulated for 3 minutes, thereby performing remote plasma etching. The pressure inside the chamber in the circulation of the etching gas was set to 500 Pa. As a remote plasma generation device, an intelligent remote plasma source ASTRON Paragon (registered trademark) manufactured by MKS Japan Inc. was used, and the source power was set to 400 W. Thus, an exposed part not covered with the silicon dioxide substrate 23 of the silicon nitride film 22 of the member to be etched was etched. After the completion of the circulation of the etching gas, the inside of the chamber was replaced with argon.

After the completion of the etching, the chamber was opened, the member to be etched was taken out, the silicon dioxide substrate 23 was removed from the taken-out member to be etched, and the bonded surface was cleaned with ethanol for removing the grease. Then, the size of the level difference between a covered surface 22a of the silicon nitride film 22 covered with the silicon dioxide substrate 23 and not etched and an etched surface 22b of the silicon nitride film 22 not covered with the silicon dioxide substrate 23 and etched was measured using an atomic force microscope VN-8010 manufactured by Keyence Corporation. The etching rate (nm/min) of silicon nitride was calculated by dividing the measured size (nm) of the level difference by the etching time (min). Table 1 shows the results.

The laminate for comparison was also subjected to the same operation as the operation for the member to be etched. Then, by dividing the size (nm) of the level difference by the etching time (min), the etching rate (nm/min) of silicon dioxide was calculated. Further, the ratio (etching selectivity ratio) of the etching rate of silicon dioxide to the etching rate of silicon nitride was calculated. Table 1 shows the results.

The conditions for measuring the size of the level difference by the atomic force microscope are as follows.
Measurement pressure: Atmospheric pressure (101.3 kPa)
Measurement temperature: 28°C
Measurement atmosphere: In the air
Scanning range: Width: 80.0 um, Height: 20.0 um, Angle: 0°

Damage to the chamber of the etching system when the member to be etched above was etched was also evaluated. The damage was evaluated by visually observing the discoloration inside the chamber after the completion of the etching. More specifically, a case where no discoloration was observed inside the chamber was determined as "A", a case where the discoloration was observed partially inside the chamber was determined as "B", and a case where the discoloration was observed entirely inside the chamber was determined as "C". Table 1 shows the results.

**[Table 1]**

| | Etching gas | | Stage temperature (°C) | Pressure inside chamber (Pa) | Source power (W) | Etching rate (nm/min) | | Etching selectivity ratio | Damage |
|---|---|---|---|---|---|---|---|---|---|
| | Composition | Flow rates*) | | | | Silicon nitride | Silicon oxide | | |
| Ex. 1 | NOF/Ar | 30/970 | 20 | 500 | 400 | 143 | 5.9 | 24.2 | A |
| Ex. 2 | NOF/Ar | 30/970 | 0 | 500 | 400 | 78 | 3.0 | 26.0 | A |
| Ex. 3 | NOF/Ar | 30/970 | 5 | 500 | 400 | 90 | 3.8 | 23.7 | A |
| Ex. 4 | NOF/Ar | 30/970 | 10 | 500 | 400 | 112 | 4.8 | 23.3 | A |
| Ex. 5 | NOF/Ar | 30/970 | 150 | 500 | 400 | 382 | 16.8 | 22.7 | A |
| Ex. 6 | NOF/Ar | 30/970 | 200 | 500 | 400 | 478 | 22.3 | 21.4 | B |
| Ex. 7 | NOF/Ar | 30/970 | 240 | 500 | 400 | 535 | 26.0 | 20.6 | B |
| Ex. 8 | NOF/Ar | 60/940 | 20 | 500 | 400 | 55 | 2.6 | 21.2 | A |
| Ex. 9 | NOF/Ar | 6/994 | 20 | 500 | 400 | 101 | 6.2 | 16.3 | A |
| Ex. 10 | NOF/Ar | 350/650 | 20 | 500 | 400 | 16 | 1.0 | 16.0 | A |
| Ex. 11 | NOF/Ar | 500/500 | 20 | 500 | 400 | 11 | 0.8 | 13.8 | B |
| Ex. 12 | NOF/Ar | 30/970 | 20 | 500 | 600 | 149 | 5.5 | 27.1 | A |
| Ex. 13 | NOF/Ar | 30/970 | 20 | 500 | 120 | 90 | 7.2 | 12.5 | A |
| Ex. 14 | NOF/Ar | 30/970 | 20 | 500 | 200 | 108 | 6.6 | 16.4 | A |
| Ex. 15 | NOF/Ar | 30/970 | 20 | 500 | 800 | 160 | 4.3 | 37.2 | B |
| Ex. 16 | NOF/Ar | 30/970 | 20 | 1000 | 400 | 116 | 5.6 | 20.7 | A |
| Ex. 17 | NOF/Ar | 30/970 | 20 | 120 | 400 | 103 | 4.9 | 21.0 | A |
| Ex. 18 | NOF/Ar | 30/970 | 20 | 200 | 400 | 111 | 5.1 | 21.8 | A |
| Ex. 19 | NOF/Ar | 30/970 | 20 | 300 | 400 | 123 | 5.6 | 22.0 | A |
| Ex. 20 | NOF/Ar | 30/970 | 20 | 2000 | 400 | 85 | 5.0 | 17.0 | A |
| Ex. 21 | NOF/Ar | 30/970 | 20 | 2500 | 400 | 72 | 4.5 | 16.0 | B |
| Comp. Ex. 1 | NOF/Ar | 30/970 | 300 | 500 | 400 | 612 | 32.2 | 19.0 | C |
| Comp. Ex. 2 | NOF/Ar | 2/998 | 20 | 500 | 400 | 84 | 6.0 | 14.0 | A |
| Comp. Ex. 3 | NOF/Ar | 30/970 | 20 | 500 | 1200 | 165 | 3.8 | 43.4 | C |
| Comp. Ex. 4 | NOF/Ar | 30/970 | 20 | 3500 | 400 | 45 | 4.1 | 11.0 | C |
| Comp. Ex. 5 | NOF/Ar | 30/970 | 20 | 500 | 0 | 0 | 0.0 | - | A |
| Comp. Ex. 6 | NOF/Ar | 30/970 | 200 | 20000 | 0 | 60 | 1.0 | 60.2 | C |
| Comp. Ex. 7 | NOF/Ar | 30/970 | 300 | 30000 | 0 | 69 | 1.1 | 62.5 | C |

| | | | | | | | | | |
|---|---|---|---|---|---|---|---|---|---|
| *) The flow rates indicate the flow rates of the nitrosyl fluoride (NOF) gas and the dilution gas. For example, a case where the flow rate of the nitrosyl fluoride (NOF) gas is 30 mL/min and the flow rate of the dilution gas was 970 mL/min is indicated as 30/970. | | | | | | | | | |

### (Examples 2 to 21 and Comparative Examples 1 to 4, 6, 7)

A silicon nitride film was set as the etching object and silicon dioxide was set as the non-etching object and the etching conditions (Composition and flow rates of the etching gas, Stage temperature, Pressure inside chamber, Source power of remote plasma generation device) were set as shown in Table 1, and then the remote plasma etching was performed in the same manner as in Example 1. Then, the etching rates of the etching object and the non-etching object were individually calculated, and the etching selectivity ratio was calculated from the numerical values. Further, damage to the chamber of the etching system was also evaluated in the same manner as in Example 1. Table 1 shows the results.

### (Comparative Example 5)

Etching was performed in the same manner as in Example 1, except that the source power of the remote plasma generation device was set to 0 W (i.e., no plasma was generated) and the etching time was set to 30 minutes. Then, the etching rates of the etching object and the non-etching object were individually calculated, and the etching selectivity ratio was calculated from the numerical values. Further, damage to the chamber of the etching system was also evaluated in the same manner as in Example 1. Table 1 shows the results.

### (Example 22)

A member to be etched used in Example 22 is described with reference to FIG. 3. The member to be etched in FIG. 3 has a structure in which 30 layers of silicon nitride films 32 with a film thickness of 35 nm and 30 layers of silicon oxide films 33 with a film thickness of 35 nm are alternately laminated on a silicon substrate 31 (FIG. 3 illustrates a structure in which five layers of the silicon nitride films 32 and five layers of the silicon oxide films 33 are alternately laminated, for convenience.). Herein, the silicon nitride film 32 is the etching object and the silicon oxide film 33 is the non-etching object. Further, the member to be etched in FIG. 3 has a through hole 34 with a diameter of 100 nm passing through the 30 layers of the silicon nitride films 32 and the 30 layers of the silicon oxide films 33 in the lamination direction.

This member to be etched was placed on a stage of an etching system having substantially the same structure as the etching system in FIG. 1, and the temperature of the stage was set to 20°C. Next, a nitrosyl fluoride gas at a flow rate of 30 mL/min and argon at a flow rate of 970 mL/min were mixed to form a mixed gas, and the mixed gas was used as an etching gas. Then, the etching gas was converted into plasma by remote plasma, and then the resultant was supplied into the chamber and circulated for 3 minutes to perform remote plasma etching. The source power of the remote plasma generation device was set to 200 W. The pressure inside the chamber in the circulation of the etching gas was set to 500 Pa. After the completion of the circulation of the etching gas, the inside of the chamber was replaced with argon.

The chamber was opened and the member to be etched was taken out. In the etched member to be etched, parts exposed to the inner surface of the through hole 34 of the silicon nitride films 32 were etched, and particularly, the silicon nitride films 32 were preferentially etched as compared with the silicon oxide films 33, and therefore the inner surface of the through hole 34 partially expands radially outward.

Parts exposed to the inner surface of the through hole 34 of the silicon oxide films 33 were difficult to be etched as compared with the silicon nitride films 32, and thus were hardly etched. Therefore, a structure was formed in which end parts of the silicon oxide films 33 projected into the through hole 34.

The taken-out member to be etched was cut, and the cross sections of the 30 layers of the silicon nitride films 32 were analyzed with a scanning electron microscope. In detail, for each of the 30 layers of the silicon nitride films 32, a radial distance between the part exposed to the inner surface of the through hole 34 of the silicon nitride film 32 and the part exposed to the inner surface of the through hole 34 of the silicon oxide film 33 was measured.

More specifically, the etching causes the inner surface of the through hole 34 to expand radially outward, increasing the radius of the through hole 34, and a difference between the radii was measured. Then, by dividing the difference by the etching time, the relative etching rate of silicon nitride to silicon oxide was calculated. The etching rate of silicon oxide was calculated by comparing the diameters of the through hole 34 before and after the etching, and a change in the diameter was hardly observed.

Then, the average value and the standard deviation of the etching rates of the 30 layers of the silicon nitride films 32 and the silicon oxide films 33 were calculated, and it was evaluated whether the relative etching rates in the in-plane direction (direction parallel to the surface of the silicon nitride film 32) of the silicon nitride films 32 vary depending on the position in the lamination direction of the silicon nitride films 32, i.e., the uniformity of the relative etching rate. Table 2 shows the results.

Further, damage to the chamber of the etching system was also evaluated in the same manner as in Example 1. Table 2 shows the results.

**[Table 2]**

| | Etching qas | | Stage temperature (°C) | Pressure inside chamber (Pa) | Source power (W) | Silicon nitride | | Silicon oxide | | Damage |
|---|---|---|---|---|---|---|---|---|---|---|
| | Composition | Flow rates*) | | | | Average value of etching rates (nm/min) | Standard deviation of etching rates (nm/min) | Average value of etching rates (nm/min) | Standard deviation of etching rates (nm/min) | |
| Ex. 22 | NOF/Ar | 30/970 | 20 | 500 | 200 | 136 | 8 | 5 | Less than 0.5 | A |
| Ex. 23 | NOF/Ar | 30/970 | 20 | 500 | 400 | 142 | 12 | 6 | Less than 0.5 | A |
| Ex. 24 | NOF/Ar | 30/970 | 20 | 500 | 800 | 158 | 13 | 7 | Less than 0.5 | B |
| Comp. Ex. 8 | NOF/Ar | 30/970 | 260 | 30000 | 0 | 66 | 6 | 1 | Less than 0.5 | C |

| | | | | | | | | | | |
|---|---|---|---|---|---|---|---|---|---|---|
| *) The flow rates indicate the flow rates of the nitrosyl fluoride (NOF) gas and the dilution gas. For example, a case where the flow rate of the nitrosyl fluoride (NOF) gas is 30 mL/min and the flow rate of the dilution gas was 970 mL/min is indicated as 30/970. | | | | | | | | | | |

### (Examples 23, 24)

Plasma etching was performed in the same manner as in Example 22 with the source power of the plasma generation device set as shown in Table 2. Then, the relative etching rate of silicon nitride to silicon oxide was calculated, and the average value and the standard deviation of the etching rates were calculated in the same manner as in Example 22. Further, damage to the chamber of the etching system was also evaluated in the same manner as in Example 1. Table 2 shows the results.

### (Comparative Example 8)

Plasma etching was performed in the same manner as in Example 22 under the etching conditions (Stage temperature, Pressure inside chamber, Source power of remote plasma generation device) as shown in Table 2. Then, the relative etching rate of silicon nitride to silicon oxide was calculated, and the average value and the standard deviation of the etching rates were calculated in the same manner as in Example 22. Further, damage to the chamber of the etching system was also evaluated in the same manner as in Example 1. Table 2 shows the results.

The results of Examples 1 to 7 and Comparative Example 1 show that, when the stage temperature is increased, the etching rates of silicon nitride which is the etching object and silicon oxide which is the non-etching object are improved. In Comparative Example 1 in which the stage temperature is 300°C, damage inside the chamber was confirmed.

It was suggested from the results of Examples 8 to 11 and Comparative Example 2 that the concentration of nitrosyl fluoride in the etching gas has a point where the etching rate of silicon nitride reaches a maximum. Similarly, it was suggested that the etching rate of silicon oxide also has a point where the etching rate of silicon oxide reaches a maximum.

The results of Examples 12 to 15 and Comparative Example 3 show that the etching rate of silicon nitride increases with an increase in the source power. On the other hand, the results show that the etching rate of silicon oxide decreases with an increase in the source power. In Comparative Example 3 in which the source power is 1200 W, damage inside the chamber was confirmed.

It was suggested from the results of Examples 16 to 21 and Comparative Example 4 that the pressure inside the chamber has a point where the etching rate of silicon nitride reaches a maximum. Similarly, it was suggested that the etching rate of silicon oxide also has a point where the etching rate of silicon oxide reaches a maximum.

The results of Comparative Example 5 show that silicon nitride is not etched when the stage temperature is 20°C under the condition where no plasma is generated.

The results of Comparative Examples 6, 7 show that the etching rates are inferior to the etching rates in Examples having the same condition of the concentration of nitrosyl fluoride in the etching gas even when the temperature of the stage and the pressure inside the chamber are adjusted under the condition where no plasma is generated. Further, damage inside the chamber was confirmed under the condition where no plasma is generated.

The results of Examples 22 to 24 show that, when a laminated film of silicon nitride and silicon oxide is etched, layers of silicon nitride can be selectively etched.

Since the ratio of the standard deviation of the etching rates to the average value of the etching rates of silicon nitride is approximately 6 to 90, it was found that the etching of the 30 layers of the silicon nitride films 32 substantially uniformly proceeds irrespective of the position in the lamination direction of the silicon nitride films 32.

In contrast thereto, the etching rate of silicon oxide was smaller than that of silicon nitride under all the conditions. Further, the standard deviation of the etching rates of silicon oxide was less than 0.5 under all the conditions.

### Reference Signs List

- 1: nitrosyl fluoride gas supply unit
- 2: noble gas supply unit
- 3: nitrosyl fluoride gas flow rate control device
- 4: noble gas flow rate control device
- 5: nitrosyl fluoride gas supply pipe
- 6: noble gas supply pipe
- 7: chamber
- 8: stage
- 9: member to be etched
- 10: exhaust pipe
- 11: thermometer
- 12: vacuum pump
- 13: pressure gauge
- 14: nitrosyl fluoride gas pressure control device
- 15: noble gas pressure control device
- 16: remote plasma generation device
- 21: silicon substrate
- 22: silicon nitride film
- 23: silicon dioxide substrate
- 31: silicon substrate
- 32: silicon nitride film
- 33: silicon oxide film
- 34: through hole

## Claims

1. An etching method comprising:
an etching step of bringing an etching gas which contains nitrosyl fluoride and has been converted into plasma into contact with a member to be etched having an etching object which is an object to be etched by the etching gas and a non-etching object which is not an object to be etched by the etching gas and selectively etching the etching object as compared with the non-etching object, wherein
the etching step is performed in a chamber containing the member to be etched using a remote plasma generation device provided outside the chamber as a plasma generation source,
a concentration of the nitrosyl fluoride in the etching gas is 0.3% by volume or more, a temperature condition of the etching step is 0°C or more and 250°C or less, and a pressure condition of the etching step is 100 Pa or more and 3 kPa or less, and
the etching object includes silicon nitride.

2. The etching method according to claim 1, wherein a source power of the remote plasma generation device of the etching step is 100 W or more and 1 kW or less.

3. The etching method according to claim 1 or 2, wherein the non-etching object includes silicon oxide.

4. The etching method according to any one of claims 1 to 3, wherein the etching gas is a mixed gas containing the nitrosyl fluoride and a dilution gas, the dilution gas is at least one selected from a nitrogen gas, helium, argon, neon, krypton, and xenon, and a concentration of the dilution gas in the etching gas is 99.7% by volume or less.

5. The etching method according to any one of claims 1 to 4, wherein the temperature condition of the etching step is 5°C or more and 200°C or less.

6. The etching method according to any one of claims 1 to 5, wherein the pressure condition of the etching step is 200 Pa or more and 2 kPa or less.

7. The etching method according to any one of claims 1 to 6, wherein the source power of the remote plasma generation device of the etching step is 200 W or more and 900 W or less.

8. A method for producing a semiconductor device for producing a semiconductor device using the etching method according to any one of claims 1 to 7,
the member to be etched being a semiconductor substrate having the etching object and the non-etching object; the method comprising:
a treatment step of removing at least a part of the etching object from the semiconductor substrate by the etching.
